# EUROPEAN PATENT APPLICATION

(11) **EP 2 431 493 A1**
(43) Date of publication of application: **21.03.2012**
(21) Application number: 11179608.2
(22) Date of filing: 31.08.2011
(51) Int. Cl.: C23C 14/24

(54) **Evaporation boat for vacuum vapor deposition and vacuum vapor deposition system**

(30) Priority: 17.09.2010 TW 099131605
(71) Applicant: Princo Corp., Hsinchu (TW)
(72) Inventor: Shih, Ying-Che, Hsinchu (TW)
(74) Representative: KATZAROV S.A.

(57) **Abstract**

Evaporation boat (20) comprising a source material container (201) configured to contain source material (204) and provided with an opening; a cover plate (202) disposed, with a predetermined gap (d), above the opening of the source material container (201), wherein the vertical projection of the cover plate (202) covers the opening of the source material container (201), so that the scattering range of the source material vapor formed by evaporating the source material is controlled by the cover plate (202) as the source material vapor scatters through the predetermined gap (d) to the outside of the evaporation boat; and a supporting member (203) connecting the source material container (201) and the cover plate (202) to maintain a predetermined gap (d) therebetween.

## Description

The content of Taiwan Patent Application No. 99131605 filed on 17 September 2010, is hereby incorporated by reference in its entirety for all purposes.

### BACKGROUND OF THE INVENTION

### [Technical Field]

The present invention relates to an evaporation boat for vacuum vapor deposition and a vacuum vapor deposition system. Specifically, the present invention relates to an evaporation boat with a cover plate, and a vacuum vapor deposition system comprising such evaporation boat.

### [Description of the Prior Art]

Vacuum vapor deposition is one of the physical vapor deposition (PVD) technologies. During the process of vacuum vapor deposition, source materials are evaporated with electrical or other heating methods. Since the environment for vapor deposition is highly vacuum, there is nearly no other gas molecules which may collide the evaporated source material molecules in the vapor deposition space. As a result, the source material molecules travel linearly in the vacuum vapor deposition space. As the evaporated source material molecules reach the surface of the object to be coated, they condense and form a thin film thereon.

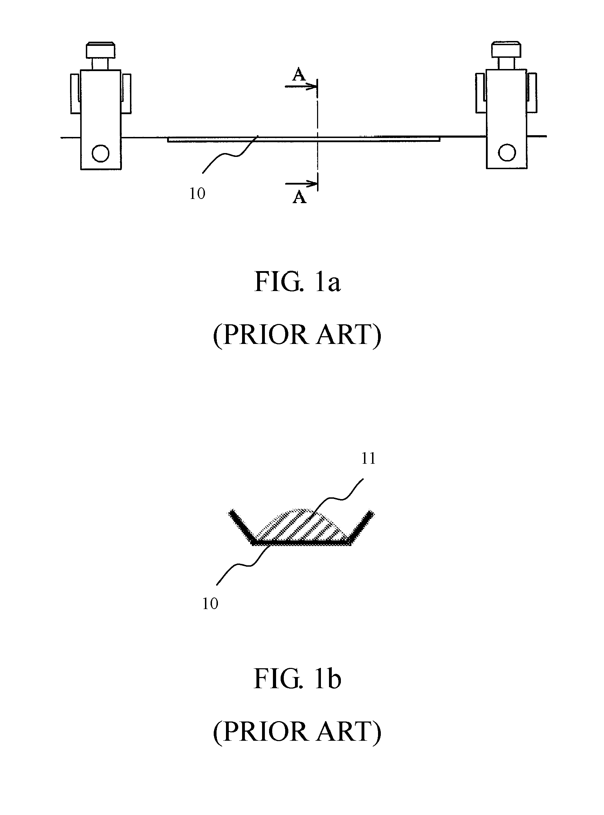

Generally, for the purpose of containing and heating source materials, metal wires, evaporation boats, or crucibles (applicable for vaporization temperature under 1500°C) which can be resistively-heated are usually employed. Among these options, evaporation boats are the most broadly used since they have advantages of low cost and operational easiness. Most evaporation boats are made of strip-like sheets of metals with high melting points, such as tungsten, molybdenum, and tantalum. FIG. 1a illustrates a conventional evaporation boat 10, and FIG. 1b is the cross-sectional view taken from line AA shown in FIG. 1a. It can be recognized from FIG. 1b that the evaporation boat 10 has an upward opening and a concave section for storing source material 11. Both ends on the longitudinal direction of the evaporation boat 10 are connected to a power source (not shown) for heating the source material 11 in the concave section of the evaporation boat 10, so that the source material 11 is evaporated to produce source material vapor.

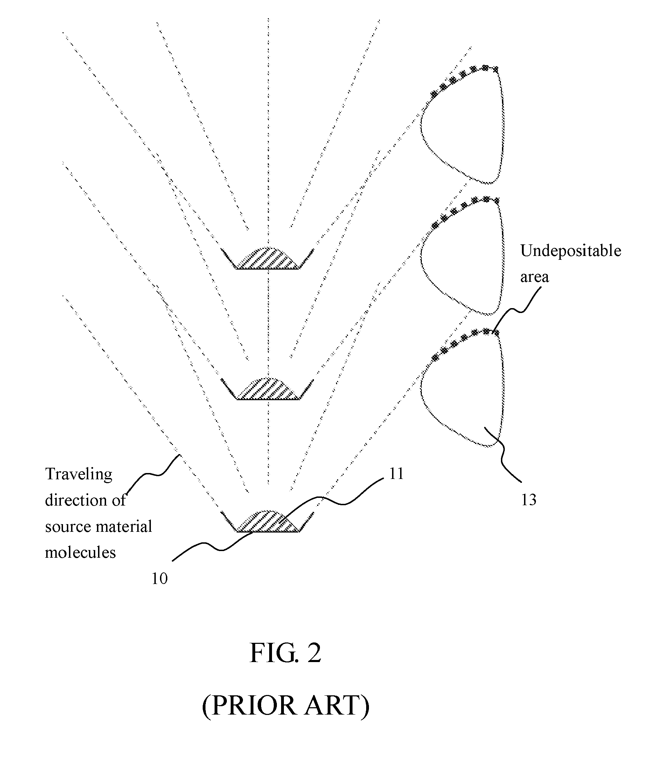

Although conventional evaporation boats have the abovementioned advantages, due to their upward-facing openings, it is preferred to place the object to be coated above the evaporation boat for achieving uniformly-deposited films. However, as an object to be coated 13 is placed beside the evaporation boat 10 as shown in FIG. 2, the scattering range of the source material vapor is limited since molecules of the source material 11 can only travel linearly in a vacuum environment. Therefore, it is difficult to form a thin film of uniform thickness on the surface of the object to be coated 13. Additionally, as shown in FIG. 2, because the scattering range of the source metal vapor is limited, when the deposited surface of the object to be coated is uneven or complex, molecules of the source material 11 may not reach certain parts of the surface of the object to be coated 13 (areas illustrated with square dots in FIG. 2). In other words, the thin film is unable to completely cover the coated surface of the object to be coated 13.

### SUMMARY OF THE INVENTION

Vacuum vapor deposition system in which the objects to be coated are disposed beside the evaporation boat, since the vapor-depositing direction of conventional evaporation boats is upwards, have following drawbacks: (1) It is difficult to achieve a required uniformity of the film thickness on the object to be coated; (2) regions that can be vapor-deposited are limited; and (3) for non-planar objects to be coated, source material vapor may not reach and attach to some areas, that is, some areas can not be deposited.

In order to solve the above problems, the present invention provides an evaporation boat for vapor deposition, comprising: a source material container configured to contain source material and provided with an opening; a cover plate disposed above the opening of the source material container with a predetermined gap, wherein the vertical projection of the cover plate covers the opening of the source material container, so that the scattering range of the source material vapor formed by evaporating the source material is controlled by the cover plate as the source material vapor scatters through the predetermined gap to the outside of the evaporation boat; and a supporting member connecting the source material container and the cover plate to maintain a predetermined gap therebetween.

The present invention also provides a vacuum vapor deposition system comprising a vacuum chamber, a workpiece rack, and the abovementioned evaporation boat. Both the workpiece rack and the evaporation boat are disposed in the vacuum chamber, and the workpiece rack for supporting objects to be coated is on a side of the evaporation boat. The source material vapor produced by evaporating the source material can diffuses through the gap between the source material container and the cover plate toward the object to be coated, and diffusion range of the source material vapor can be controlled with the cover plate.

The present invention allows the source material vapor produced by evaporating the source material to escape sideward from the evaporation boat. In addition, by adjusting the abovementioned gap between the source material container and the cover plate, the range of vapor deposition can be controlled within a proper angular region. Thus, the present invention can: (1) enable the source material vapor to be exhaled to the object to be coated beside the evaporation boat and form a uniform film thereon; (2) increase the diffusion range of the source material vapor; and (3) make the source material vapor attach to the whole deposited surface of a non-planar object to form a film.

### BRIEF DESCRIPTION OF THE DRAWINGS

FIG. 1a illustrates a conventional evaporation boat.

FIG. 1b is a cross-sectional view taken from line AA in FIG. 1a.

FIG. 2 is a schematic view showing the diffusion range of the source material vapor and the coverage of the deposited film when employing the conventional evaporation boat to perform vapor-deposition on the objects to be coated disposed beside the evaporation boat.

FIG. 3 shows a vacuum vapor deposition system comprising the evaporation boat of the present invention.

FIG. 4a is a front view of the evaporation boat according to an embodiment of the present invention.

FIG. 4b is a cross-sectional view taken from line BB in FIG. 4a.

FIG. 5 is a schematic view showing the scattering range of source material vapor when employing the evaporation boat according to an embodiment of the present invention to perform vapor-deposition on the objects to be coated disposed beside the evaporation boat.

FIG. 6a is a schematic diagram of a configuration for testing the optimal parameter settings of the evaporation boat of the present invention.

FIGs. 6b and 6c are respectively the distributions of red chromaticity (a value) and yellow chromaticity (b value) of the deposited film on test pieces.

FIG. 7 is a film thickness distribution diagram of deposited films formed by employing the evaporation boat of the present invention and a conventional evaporation boat.

FIG. 8 shows the coverage of deposited films when performing vapor-deposition on non-planar objects with the evaporation boat according to an embodiment of the present invention.

FIG. 9 is a cross-sectional view of an evaporation boat according to another embodiment of the present invention.

FIG.10 shows an embodiment of the supporting member of the evaporation boat of the present invention.

### DETAILED DESCRIPTION OF THE PREFERRED EMBODIMENTS

Embodiments of the present invention will be described in the following with reference to the accompanying drawings.

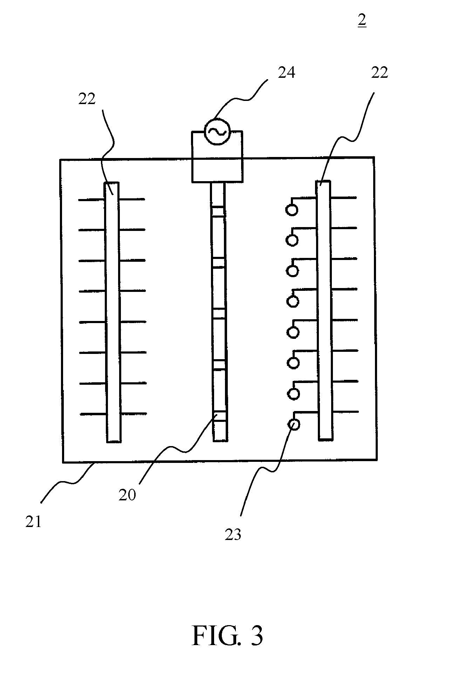

FIG. 3 shows the vacuum vapor deposition system 2 according to an embodiment of the present invention comprising: an evaporation boat 20, a vacuum chamber 21, and a workpiece rack 22 for holding objects to be coated 23. As shown in FIG. 3, the evaporation boat 20 is electrically connected to a power source 24, while the workpiece rack 22 is disposed beside the evaporation boat 20.

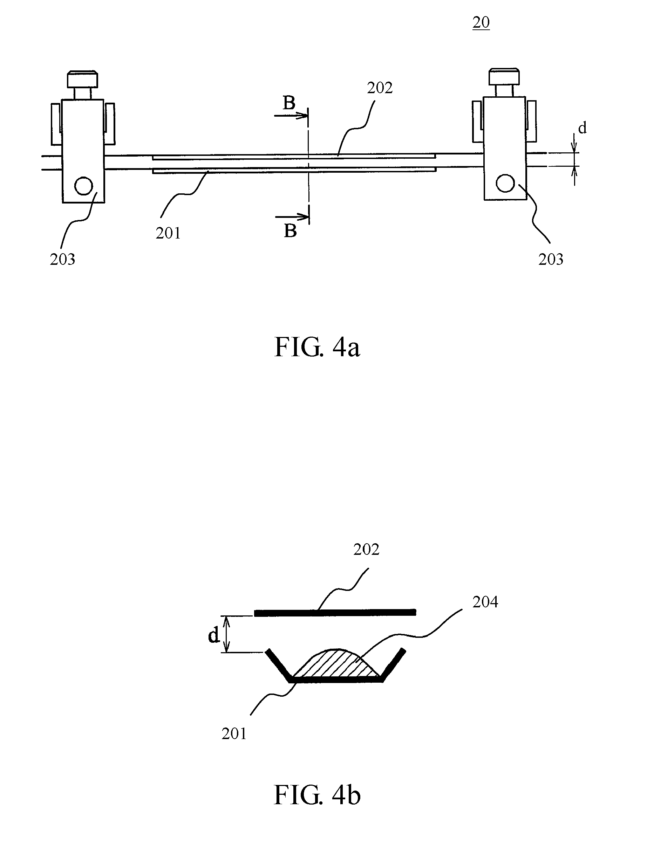

FIG. 4a. illustrates an embodiment of the evaporation boat 20 of FIG. 3, and FIG. 4b is a cross-sectional view taken from line BB in FIG. 4a. As shown in FIGs. 4a and 4b, the evaporation boat 20 comprises: a source material container 201 for containing a source material 204, which is provided with an upward opening so that the heated and evaporated source material can diffuse from the source material container 201 and pass through the opening; a cover plate 202 disposed above the source material container 201 with a predetermined gap d ranging from 1mm to 10mm, wherein the vertical projection of the cover plate 202 covers the opening of the source material container 201; and a supporting member 203 connecting the source material container 201 and the cover plate 202. The width of the opening of the source material container 201 is for example between 3mm and 10mm, and the width of the cover plate also ranges for example from 3mm to 10mm.

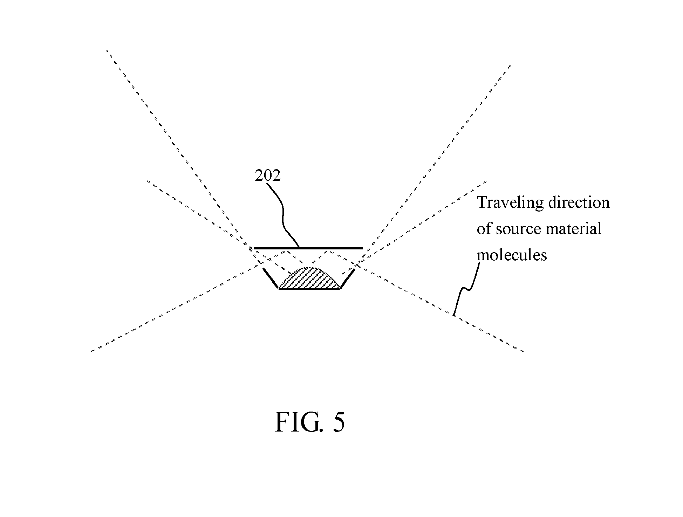

Referring to FIGs. 3, 4a and 4b, during the process of vacuum vapor deposition, the evaporation boat 20 and the workpiece rack 22 on which the objects to be coated 23 are held are disposed in the vacuum chamber 21. For heating the evaporation boat 20, the power source 24 applies electricity thereto, so that the source material 204 in the source material container 201 is evaporated, and therefore source material vapor is produced. In a highly vacuum environment, the source material molecules in the source material vapor travel linearly as rays of light. Therefore, after passing the opening of the source material container 201, the source material molecules in the source material vapor may directly leave the evaporation boat 20 along specific routes through the gap *d* between the source material container 201 and the cover plate 202, or leave the evaporation boat 20 through the gap d after one or more collisions with the cover plate 202 and/or the source material container 201. In other words, as shown in FIG. 5, the cover plate 202 makes a part of the source material molecules scattering upwards alter their travel direction by way of collision, so that the source material molecules can be controlled to move in any sideward direction (angle). Thus, the range of deposition can be effectively expanded. When the source material vapor arrives at the surface of the object to be coated 23 where the temperature is lower, the source material condenses on the surface of the object to be coated 23 and a film is formed thereon.

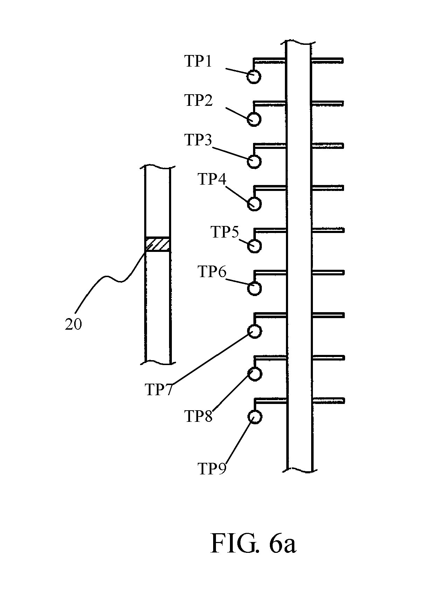

According to an embodiment, in order to optimize the range of deposition, in each of the evaporation boats used in a vapor deposition process, a fixed-width source material container is for example combined with cover plates of different widths. Further, proper measuring methods are employed to measure the deposited film and analyze the range and effect of the vapor deposition process. The parameter settings are for example as follows: one evaporation boat is used, wherein the width of the source material container is 5mm; the widths of the cover plates are 5mm, 6mm, 7mm and 8mm respectively, and the material thereof is tungsten; the gap between the source material container and the cover plate is 3mm; 2 grams of copper (Cu) is used as the source material; and the objects to be coated are circular stainless steel (SUS304) test pieces with an identical diameter of 30mm. The test pieces are configured with reference to the evaporation boat. As shown in FIG. 6a, a test piece TP5 is disposed approximately at the same level as a side of the evaporation boat 20, and 2 groups of 4 test pieces (TP1-TP4 and TP6-TP9) are respectively disposed above and below the side of the evaporation boat, wherein the distance between two vertically adjacent test pieces is 85mm.

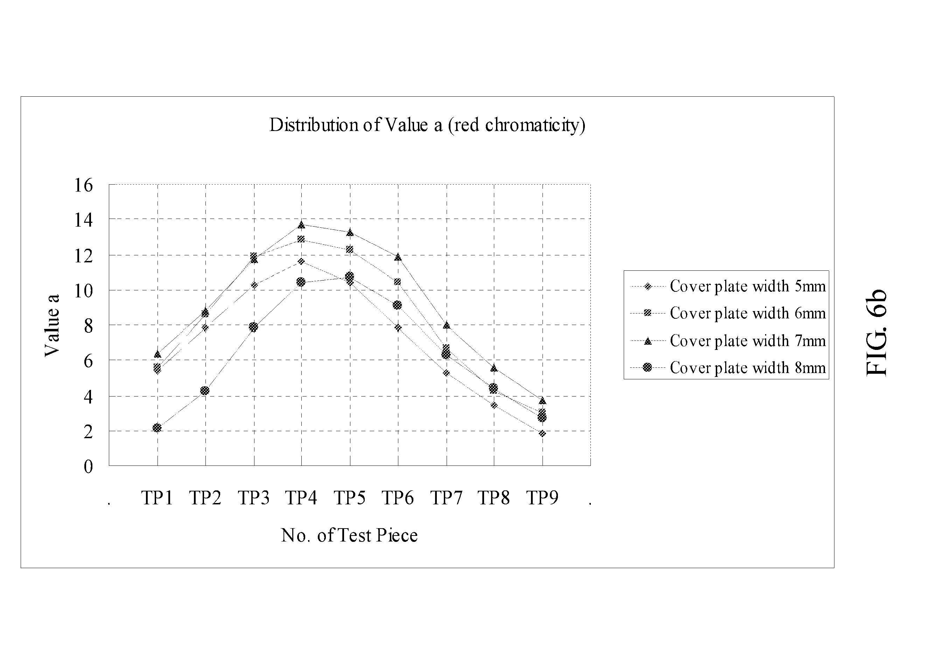

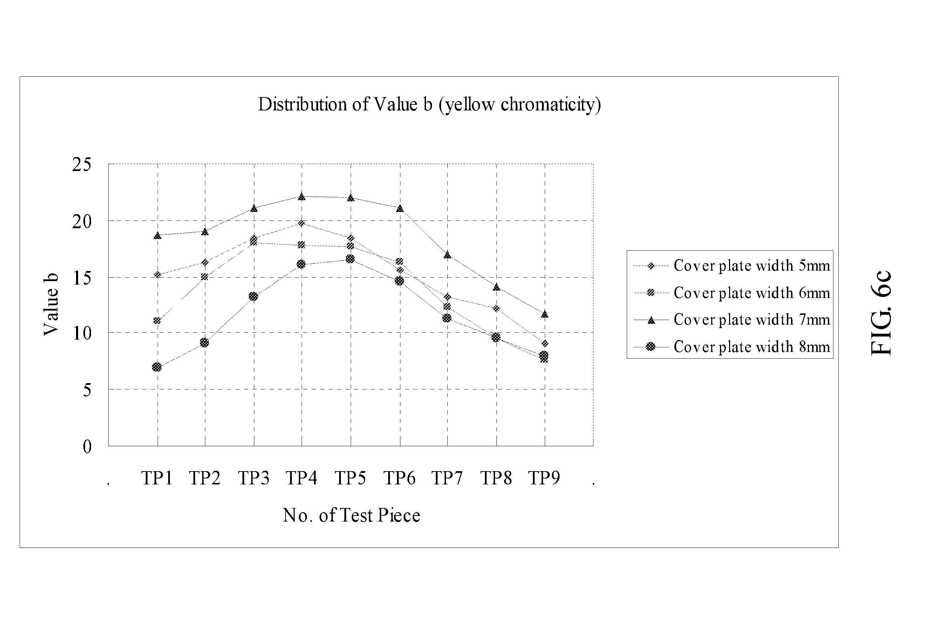

Since copper is chosen as the source material, a colorimeter is employed to measure the red chromaticity (value a) and yellow chromaticity (value b) of the entire area of each test piece, and the range of deposition is analyzed based on the result of measurement in which higher values a and b represent thicker deposited copper film. As shown in FIGs. 6b and 6c, when the width of the cover plate is increased to 8mm, the values a and b of TP5 are the highest among those of all the test pieces, and the values a and b of the other test pieces are nearly symmetrically distributed around these maximum values. In other words, the configuration for the width of the cover plate can lead to almost identical deposition ranges above and below the side of the evaporation boat.

In addition, since there is an obvious color difference between the copper film and the stainless steel test piece, after completing the aforementioned vapor deposition process on the nine test pieces using one evaporation boat, it can be recognized through visual inspection if films are formed on the test pieces. If the deposition range of one evaporation boat is expressed in form of elevation angle and depression angle from the level of the evaporation boat, the result of measurement is shown as Table 1.

**Table 1**

| Width of Cover Plate | Elevation Angle of Deposition Range(degree) | Depression Angle of Deposition Range(degree) |
|---|---|---|
| 5mm | 45 | 15 |
| 6mm | 40 | 17 |
| 7mm | 40 | 22 |
| 8mm | 35 | 30 |

It can be understood from Table 1 that, for achieving approximately identical elevation angle and depression angle of the deposition range of the evaporation boat, the optimum parameter settings are:

The width of the source material container: 5mm;

The width of the cover plate: 8mm; and

The gap between the source material container and the cover plate: 3mm.

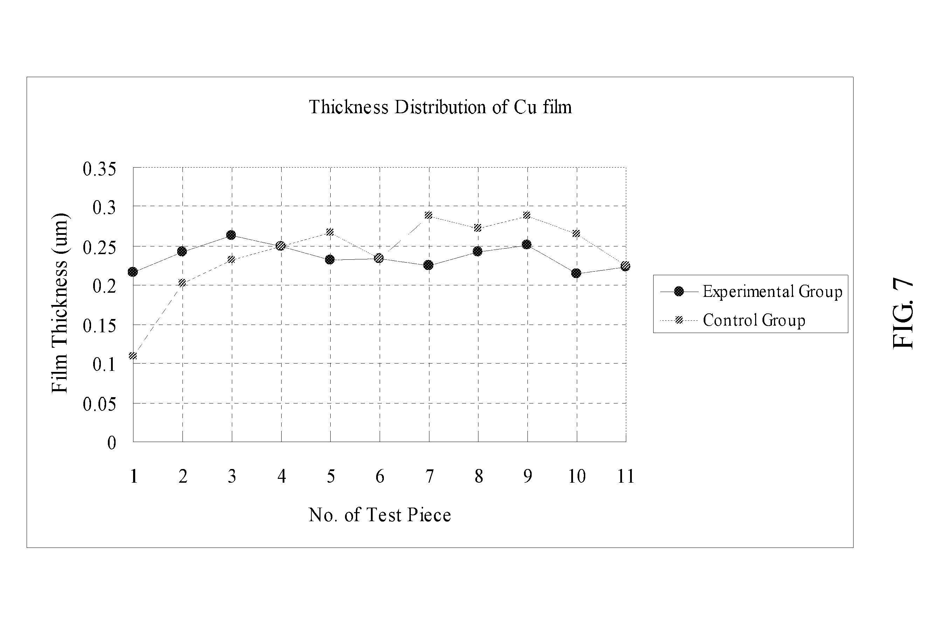

Next, in a vapor deposition system 2 as shown in FIG. 3, for example 14 evaporation boats with the above optimum settings are vertically disposed and separated (experimental group). On the other hand, as a control group, 14 conventional evaporation boats without cover plates are used for vapor deposition under the same condition and configuration. 2 grams of copper is placed in each source material container as source material, and 11 stainless steel (SUS304) test pieces which are 30mm in diameter are employed as objects to be coated. The distance between two vertically adjacent evaporation boats is 30mm, while that between two vertically adjacent test pieces is 85mm. After the vapor deposition process is completed, in order to understand the distribution of the thickness of the formed films, a scanning electron microscope (SEM) is used for measuring the thicknesses of the films formed on each of the test pieces in the experimental group and the control group, wherein the test pieces are measured at the centers thereof. FIG. 7 illustrates the results of measurement for the thicknesses of the copper films on each of the test pieces in the experimental group and the control group. It can be derived from the results shown in FIG. 7 that: the average and standard deviation of the film thicknesses of the experimental group (the present invention) are 0.236µm and 0.017µm respectively; and the average and standard deviation of the film thicknesses of the control group (prior art) are 0.240µm and 0.055µm respectively. Although the average film thicknesses of both groups are very close, the standard deviation of the thicknesses of the copper films deposited with the evaporation boats of the present invention is much lower than that of the copper films deposited with conventional evaporation boats. Thus, by employing the evaporation boat according to an embodiment of the present invention, the thickness distribution of the deposited film tends to be more even.

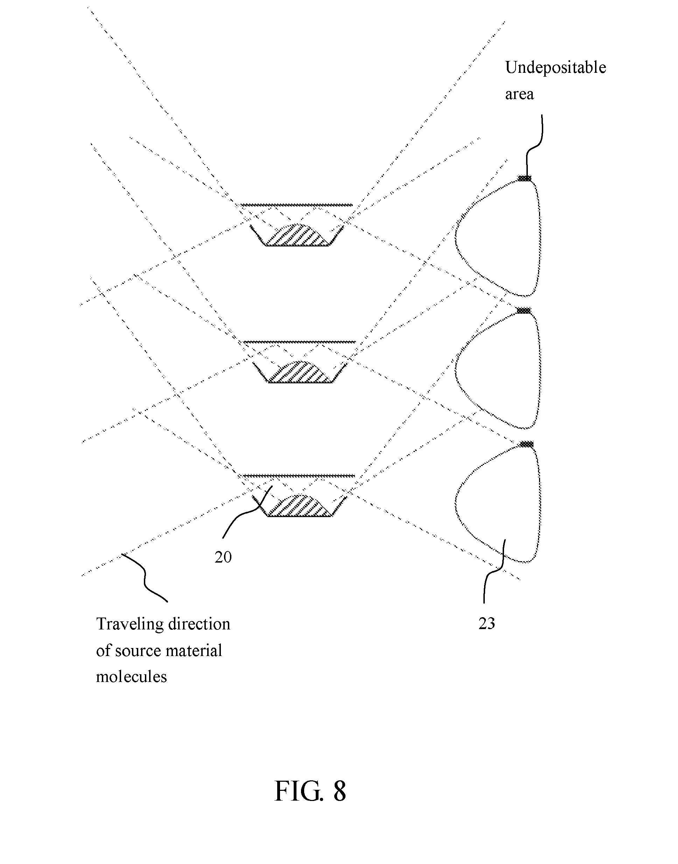

For a non-planar object to be coated, the area unable to be covered by the film can be substantially reduced by employing the evaporation boat of the present invention. Referring back to FIG. 2 which shows the coverage of the film deposited with conventional evaporation boats, since the source material vapor can only travels sideward within a limited range, part of the surface of the object to be coated 13 is unable to be deposited (area illustrated with square dots) when the object to be coated 13 is placed beside the evaporation boat 10. Referring to FIG. 8, when the evaporation boat 20 of the present invention is used for depositing on non-planar object to be coated 23 beside the evaporation boat 20, the traveling range of the source material vapor toward the side of the evaporation boat can be controlled and expanded, and the result of deposition is shown in FIG.8. Compared to the conventional evaporation boat, the undepositable area (square-dotted area) is obviously smaller. In other words, the present invention can reduce the undepositable area of the non-planar object to be coated placed beside the evaporation boat.

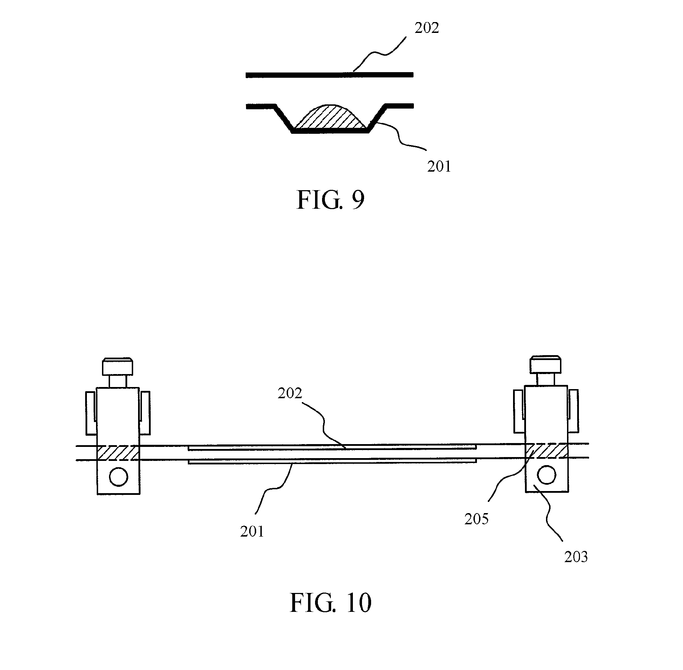

According to variant embodiments, in addition to the bowl-section structure shown in FIG. 4b, the source material container 201 can be provided with a plate-section structure as shown in FIG. 9. The edge portion of the source material container 201 with a plate-section structure forms a channel structure together with the cover plate 202, so that the adjustment for the scattering direction and range of the source material vapor becomes easier and more accurate.

Although the material of the cover plate in the evaporation boat of the present invention is not limited, the cover plate is preferred to be made of tungsten, molybdenum, tantalum or ceramics.

In the supporting member 203 of the evaporation boat of the present invention, a spacer 205 can be used for adjusting the gap between the source material container 201 and the cover plate 202. For example, as shown in FIG. 10, since the spacer 205 in the supporting member 203 is disposed between the source material container 201 and the cover plate 202, by applying spacers 205 of various thicknesses, the supporting member 203 can hold the source material container 201 and the cover plate 202 while maintaining the gap therebetween at a required distance.

While a description for the technical features of the invention has been made in terms of several exemplary embodiments, it is made for exemplifying but not limiting. In other words, without departing from the true spirit and novel teachings of the present invention, those skilled in the art may produce a variety of alterations and modifications which are covered in the scope of the appended claims below.

## Claims

1. Evaporation boat (20) for vapor deposition, comprising:
a source material container (201) configured to contain source material (204) and provided with an opening;
a cover plate (202) disposed above the opening of the source material container (201) with a predetermined gap (d), wherein the vertical projection of the cover plate (202) covers the opening of the source material container (201), so that the diffusion range of the source material vapor formed by evaporating the source material (204) is controlled by the cover plate (202) as the source material vapor diffuses through the predetermined gap to the outside of the evaporation boat (20); and
a supporting member (203) connecting the source material container (201) and the cover plate (202) to maintain the predetermined gap therebetween.

2. Evaporation boat (20) according to claim 1, wherein the cover plate (202) is made of tungsten, molybdenum, tantalum or conductive ceramics.

3. Evaporation boat (20) according to any preceding claim, wherein the source material container (201) has a plate-like or bowl-like structure.

4. Evaporation boat (20) according to any preceding claim, wherein the predetermined gap is between 1mm and 10mm.

5. Evaporation boat (20) according to any preceding claim, wherein the width of the source material container (201) is between 3mm and 10mm, and the width of the cover plate (202) is between 3mm and 10mm.

6. Evaporation boat (20) according to any preceding claim, wherein the supporting member (203) comprises a spacer (205), wherein the predetermined gap between the source material container (201) and the cover plate (202) is adjustable by applying the spacers (205) having different thicknesses.

7. Vacuum vapor deposition system (2), comprising:
a vacuum chamber (21) providing a vacuum environment;
a workpiece rack (22) disposed in the vacuum chamber (21) for supporting objects to be coated (23); and
an evaporation boat (20) disposed in the vacuum chamber (21) and positioned on a side of the workpiece rack (22), the evaporation boat (20) comprising:
a source material container (201) configured to contain source material (204) and provided with an opening;
a cover plate (202) disposed above the opening of the source material container (201) with a predetermined gap (d), wherein the vertical projection of the cover plate (202) covers the opening of the source material container (201), so that the scattering range of the source material vapor formed by evaporating the source material (204) is controlled by the cover plate (202) as the source material vapor scatters through the predetermined gap (d) to the objects to be coated (23); and
a supporting member (203) connecting the source material container (201) and the cover plate (202) to maintain the predetermined gap (d) therebetween.

8. Vacuum vapor deposition system (2) according to claim 7, wherein the cover plate (202) of the evaporation boat (20) is made of tungsten, molybdenum, tantalum or conductive ceramics.

9. Vacuum vapor deposition system (2) according to claim 7 or 8, wherein the source material container (201) has a plate-like or bowl-like structure.

10. Vacuum vapor deposition system (2) according to any one of claims 7 to 9, wherein the predetermined gap (d) is between 1mm and 10mm.

11. Vacuum vapor deposition system (2) according to any one of claims 7 to 10, wherein the width of the source material container (201) is between 3mm and 10mm, and the width of the cover plate (202) is between 3mm and 10mm.

12. Vacuum vapor deposition system (2) according to any one of claims 7 to 10, wherein the supporting member (203) comprises a spacer (205), wherein the predetermined gap (d) between the source material container (201) and the cover plate (202) is adjustable by applying the spacers (205) having different thicknesses.
